# EUROPEAN PATENT APPLICATION

(11) **EP 3 188 335 A1**
(43) Date of publication of application: **05.07.2017**
(21) Application number: 15203191.0
(22) Date of filing: 30.12.2015
(51) Int. Cl.: H02J 3/36, H02J 3/38

(54) **ELECTRICAL GENERATOR UNIT**

(71) Applicant: Openhydro IP Limited, Dublin 2 (IE)
(72) Inventor: SPOONER, Edward, Bishop Auckland, Durham DL13 1SL (GB); CAWTHORNE, Simon, Carlingford, County Louth (IE)
(74) Representative: Wallace, Alan Hutchinson

(57) **Abstract**

An electrical generator unit comprises an electrical generator and a plurality of AC to DC converters. Each converter is coupled to the generator to receive an AC electrical input and is configured to produce a respective DC electrical output. The converter outputs are connected together in series to provide the DC generator unit output. The converters may be VSI converters. The generator unit is particularly suited for use as part of a hydroelectric turbine generator.

## Description

### Field of the Invention

This invention relates to electrical generator units. The invention relates particularly to turbine generator units, especially but not exclusively hydroelectric turbine generator units.

### Background to the Invention

Turbines are recognised as a means for effectively harnessing a clean and renewable energy source. Groups of hydroelectric turbines, installed in the sea, exploit natural currents caused by tides or by river flows near estuaries, to generate electrical power for provision to utility grids, generally provided on shore.

Installation and maintenance of hydroelectric turbines at sea is expensive and hazardous. The housing for the generator and associated equipment is a particularly expensive component of the undersea installation. Also, the size and weight of the undersea installation can cause installation problems, in particular overcoming upthrust. It would be desirable therefore to minimize the size of the housing. One way to achieve this is to provide as few components of the generator system as possible in the undersea housing and/or to reduce the size of the components. However, this must be balanced against the need to transmit electrical power efficiently to shore.

### Summary of the Invention

A first aspect of the invention provides an electrical generator unit for providing a DC electrical output, the generator unit comprising:
an electrical generator configured to produce an AC electrical output;
a plurality of AC to DC converters, each converter being coupled to the generator to receive an AC electrical input from said AC electrical output, and being configured to produce a respective DC electrical output at a respective converter output,
wherein said respective converter outputs are connected together in series to provide the output of said generator unit.

In preferred embodiments each of said AC to DC converters comprises a voltage source converter.

Typically each converter output and said generator output comprise respective DC terminals, the respective DC terminals of each converter being connected in series between the DC terminals of said generator unit. Preferably at least one respective shunt capacitor is provided across each converter output.

Typically said generator comprises a plurality of generator winding groups, a respective AC to DC converter being coupled to a respective winding group to receive said respective AC electrical input from said respective winding group.

In preferred embodiments said AC to DC converters are coupled to said generator by at least one transformer. At least some and optionally all of said AC to DC converters may be coupled to said generator by a respective transformer. At least some and optionally all of said AC to DC converters may be coupled to a respective generator winding group by a respective transformer.

Said at least one transformer may comprise a step up transformer, or a step down transformer, or a transformer with a 1:1 voltage transform ratio.

Preferably, at least two of said AC to DC converters are coupled to said generator by a common transformer. Optionally each of said AC to DC converters is coupled to said generator by a common transformer. Typically, said common transformer comprises at least one generator side transformer winding and at least one converter side winding. Optionally said common transformer comprises at least one respective converter side winding connected to a respective one of said at least two AC to DC converters. In typical embodiments, said generator comprises a plurality of generator winding groups, said common transformer comprising at least one respective generator side winding connected to a respective one of said generator winding groups.

Optionally, said generator comprises at least one generator winding group by which it is coupled to said common transformer, and wherein the number of AC to DC converters coupled to said common transformer is not equal to the number of winding groups coupled to said common transformer.

Alternatively, said generator comprises at least one generator winding group by which it is coupled to said common transformer, and wherein the number of AC to DC converters coupled to said common transformer is equal to the number of winding groups coupled to said common transformer.

Said generator typically includes at least one set of at least one generator winding, and typically at least one generator winding group comprising a respective plurality of said sets, each generator winding group usually comprising a respective set for each phase of the AC output of the generator.

Typically said common transformer has a respective generator side transformer winding connected to said at least one set of at least one generator winding. Said common transformer may have a respective generator side transformer winding connected to each set of each winding group that is coupled to the transformer.

In typical embodiments, said at least two AC to DC converters each has at least one respective input, typically a plurality of inputs, usually a respective input for each phase of the AC output of the generator, said common transformer having a respective converter side transformer winding connected to each input.

Typically, said at least two AC to DC converters are multi-phase, typically three phase, converters, having a respective input for each phase, said common transformer having a respective converter side transformer winding connected to each input, and coupled in use to at least one generator side winding for the respective phase.

Optionally said at least two AC to DC converters are single phase converters having a respective single phase input, said common transformer having a respective converter side transformer winding connected to each input, and coupled in use to at least one generator side winding for the respective phase.

Typically, said transformer has at least one transformer core element, wherein at least one generator side winding and at least one converter side winding are located around a common core element. Optionally the number of converter side windings and the number of generator side windings provided around a respective common core are unequal. Optionally the turns ratio between said at least one generator side winding and at least one converter side winding located around a common core element is 1:1. Alternatively the turns ratio between said at least one generator side winding and at least one converter side winding located around a common core element is other than 1:1.

Typically, the transformer has a plurality of core elements, a respective set of one or more generator side windings and converter side windings being located around each core element. The transformer may have a respective core element for each phase of the generator AC output, a respective set of one or more generator side windings and converter side windings for each phase being located around the respective core element for the respective phase.

Optionally, said generator side windings and said converter side windings are arranged such that they do not overlap with one another along the length of the respective core element, each winding preferably being separated from each adjacent winding by electrical insulation. Said generator side windings and said converter side windings may be located alternately along the length of the respective core element. Alternatively said converter side windings may be provided in a group between two sets of the respective generator side windings.

In some embodiments, said generator comprises at least one generator winding group having a respective set of one or more generator windings for each phase of the AC output of the generator, each set being included in a respective electrically separate winding circuit, wherein each winding circuit includes a respective transformer side winding in series with the or each generator winding of the respective set, said respective winding circuit further including a respective normally closed switching device operable to break the respective winding circuit in the event of a fault, said generator unit further including fault detection means configured to detect a fault in any one of said winding circuits, and in response to detecting a fault to cause the respective switching device to break the respective winding circuit. Preferably the respective switching device is located in series between the respective transformer winding and the respective set of one or more generator windings. Each winding circuit may include a respective resistor connected between the winding circuit and electrical earth, the fault detection means being arranged to monitor the current flowing through the resistor and to detect a fault if the current exceeds a threshold level. The generator unit may further include means for operating the respective switching device to break the respective winding circuit in response to detection of a fault at the output of the generator unit.

In preferred embodiments said generator is coupled to a turbine, preferably a tidal current turbine.

Optionally a respective fuse is provided at the, or each, input of each AC to DC converter.

Optionally a respective diode is provided in shunt across each converter output.

Optionally at least one diode is provided in series with the generator unit output to prevent current flowing into the output.

Some embodiments may comprise an energy storage system, the energy storage system comprising an auxiliary AC-DC converter coupled to said at least one transformer, and one or more energy storage device, for example one or more capacitors, provided at the output of the auxiliary AC-DC converter. The auxiliary converter may be operable in a first mode in which AC power received from the generator via the transformer in use is stored in the or each energy storage device. The auxiliary converter may be operable in a second mode in which stored DC energy is converted to AC power by the converter and provided to the generator via said at least one transformer. Optionally an auxiliary DC-AC converter is connected to the output of the auxiliary AC-DC converter and is operable to provide an auxiliary AC power output.

Another aspect of the invention provides an electrical generator for generating an AC electrical output, the generator comprising at least one generator winding group having a respective set of one or more generator windings for each phase of the AC output of the generator, each set being included in a respective electrically separate winding circuit, wherein each winding circuit includes a respective transformer winding in series with the or each generator winding of the respective set, said respective winding circuit further including a respective normally closed switching device operable to break the respective winding circuit in the event of a fault, said generator unit further including fault detection means configured to detect a fault in any one of said winding circuits, and in response to detecting a fault to cause the respective switching device to break the respective winding circuit.

From another aspect, the invention provides a turbine generator unit comprising an electrical generator unit of the first aspect, wherein said generator is coupled to a turbine, preferably a tidal current turbine.

A further aspect of the invention provides an electrical generator unit array for producing an array DC electrical output, the array comprising a plurality of generator units, each generator unit including an electrical generator configured to generate an AC output, and at least one AC to DC converter coupled to said generator and configured to produce a DC electrical output at an output of said generator unit, wherein the respective output of said generator units are connected in parallel to provide the array DC electrical output, and wherein the array is connectable to a receiving station by at least two output power transmission cables, each transmission cable being connected to a respective one of the generator units being array output units, whereby said array DC electrical output is transmittable to the receiving station by any one or each of the array output units, and wherein each array output unit is connected to at least one other of the generator units in order to receive the DC output from the respective connected generator unit, and each generator unit that is not an array output unit is connected to one or more array output unit and/or to one or more other non-array output generator unit so that its DC output is transmittable to any one or each of the units to which it is connected and so that the DC output of each generator unit is transmittable to said at least two output transmission cables, the respective connections between the respective units being made by a respective inter-unit power transmission cable.

In preferred embodiments, each generator unit includes at least two switching devices that, in a non fault operating mode, connect the generator unit to a respective one of the respective transmission cables. Preferably said array further includes fault detection means for detecting a fault at least in the inter-unit transmission cables, and wherein, in response to detection of a fault in any one of said inter-unit cables, said fault detection means is configured to cause the respective switch devices at each end of the faulty cable to open to disconnect the respective generator units from the faulty cable.

The array typically further includes output control means for selectably reducing the DC output from each generator unit, preferably to zero or substantially zero, in response to detection of a fault, wherein said fault detection means is configured to open the respective switch after the DC output from each generator unit has been so reduced. Said output control means may comprise one or more switching devices in each generator unit. Preferably each generator unit is configured to detect faults and to reduce its DC output, preferably to zero or substantially zero, upon detection of a fault.

Preferably, the fault detection means is configured to detect the direction of current flow, and to detect a fault in any one of said inter-unit transmission cables upon determining that current is flowing into the transmission cable at one both ends.

Optionally said fault detection means comprises, in each generator unit, a respective fault detection device for each transmission cable to which the unit is connected. Each fault detection device may be configured to detect the direction of current flow into the respective transmission cable from the respective generator unit. The respective fault detection devices of any two interconnected generator units that are configured to detect faults in the inter-unit transmission cable connecting the two generator units may be coupled together and configured to detect a fault upon determining that current is flowing into the transmission cable at one both ends.

In typical embodiments, at least the generator units that are not array output units are connected to at least two other generator units. Optionally all of the generator units in the array are connected to at least two other generator units.

Preferably, the generator units are inter-connected by said inter-unit transmission cables such that the DC output from any one of the generator units can be provided to any one or each of the output power transmission cables either directly, or by a direct connection to an array output unit, and/or by an indirect connection to an array output unit by connection to one or more non-array output units.

Optionally said generator units are interconnected by said inter-unit cables to form a ring.

Each generator unit may have at least two of said switching devices, each being operable to connect or disconnect the generator unit to/from a respective other generator unit in the array. Each array output unit may have an additional switching device for connecting and disconnecting it to/from the respective output power transmission cable.

In preferred embodiments said fault detection means is configured to detect a fault in any one of said output power transmission cables, and wherein, in response to detection of a fault in any one of said output power transmission cables, said fault detection means is configured to cause the respective switch device at the respective array output unit to open to disconnect the respective array output unit from the faulty cable. Said fault detection means may be configured to detect a fault in any one of said output power transmission cables by detecting that the DC current at an array end of the respective output power transmission cable exceeds the DC current at a receiving station end of the respective output power transmission cable.

Optionally said generator units are interconnected by said inter-unit cables to form at least one string of two or more generator units. Said generator units may be interconnected by said inter-unit cables to form a plurality of said strings, each string having first and second generator units connected to a respective first or second generator unit of one or more other of said strings. Each of said first and second generator units may have an additional switching device for connecting and disconnecting it to/from a respective inter-unit power transmission cable by which it is connected to said respective first or second generator unit of another of said strings.

In preferred embodiments each generator unit of the array comprises:
a plurality of AC to DC converters, each converter being coupled to the generator to receive an AC electrical input from said AC electrical output, and being configured to produce a respective DC electrical output at a respective converter output,
wherein said respective converter outputs are connected together in series to provide the output of said generator unit.

Said one or more switching devices may comprise a respective switching device operable to isolate a respective generator winding, generator winding circuit branch or generator winding group from the or each respective AC to DC converter.

In preferred embodiments, the respective generator is coupled to the respective AC to DC converter by at least one transformer, and wherein said one or more switching devices comprise a respective switching device operable to isolate the respective generator, for example a respective generator winding, generator winding circuit branch or generator winding group, from said at least one transformer.

In preferred embodiments, each generator unit of the array is a turbine generator unit, the generator being coupled to a turbine, preferably a tidal current turbine.

In preferred embodiments, a modular converter concept is employed whereby a plurality of relatively low-voltage AC to DC converters, preferably VSI converters, are connected in series at their DC terminals to create a relatively high-voltage DC output to transmit power efficiently to shore.

Further advantageous aspects of the invention will be apparent to those ordinarily skilled in the art upon review of the following description of a specific embodiment and with reference to the accompanying drawings.

### Brief Description of the Drawings

Embodiments of the invention are now described with reference to the accompanying drawings in which like numerals are used to denote like parts and in which:
Figure 1 is a schematic view of a turbine generator system;
Figure 2 is a schematic view of an array of offshore hydroelectric turbine generator units connected to an onshore electrical grid;
Figure 3 is a schematic view of a first electrical generator unit embodying a first aspect of the invention;
Figure 4 is a schematic view of a second electrical generator unit embodying said first aspect of the invention;
Figure 5 is a schematic view of a third electrical generator unit embodying said first aspect of the invention;
Figure 6 is a schematic view of a fourth electrical generator unit embodying said first aspect of the invention;
Figure 7 is a schematic view of a fifth electrical generator unit embodying said first aspect of the invention;
Figure 8 is a schematic view of an electrical transformer suitable for use with any one of the second to fifth electrical generator units;
Figure 9 is a schematic view of part of an alternative electrical transformer suitable for use with any one of the second to fifth electrical generator units;
Figure 10 is a schematic view of a generator protection system suitable for use with any one of the second to fifth electrical generator units and embodying a further aspect of the invention;
Figure 11 is a schematic view of a converter module with fault protection circuitry, the module being suitable for use with any one of the first o fifth electrical generator units;
Figure 12 is a schematic view of an ancillary power system suitable for use with any one of the second to fifth electrical generator units;
Figure 13 is a schematic view of an array of turbine generator units embodying another aspect of the invention;
Figure 14 is a schematic view of a turbine generator unit suitable for use in the array of Figure 13; and
Figure 15 is a schematic view of a cable fault detection device suitable for use with the array of Figure 13.

### Detailed Description of the Drawings

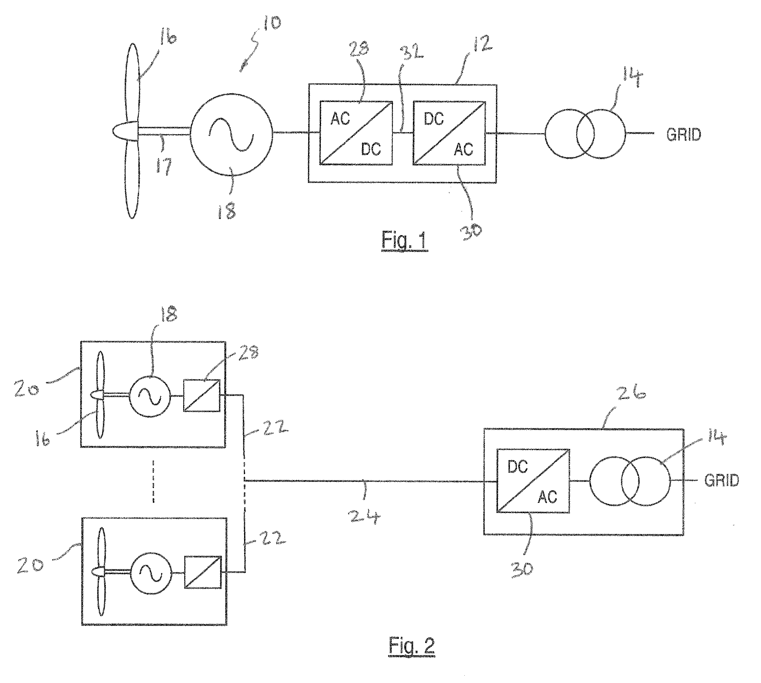

Figure 1 shows a block diagram of an electrical generator system comprising a turbine generator 10 for supplying electrical power to an electrical grid via a power converter system 12 and typically also vai a transformer 14. The turbine generator 10 comprises a turbine 16 coupled to an electrical generator 18. The turbine 16 is driven by a fluid, typically air or water, the specific construction of the turbine 16 typically depending at least in part on the driving fluid. The most common types of turbine generators 10 are driven by wind or by tidal streams / currents. In preferred embodiments of the present invention, the turbine generator 10 is a hydroelectric turbine generator, although the invention may alternatively be embodied in a wind turbine electrical generator system. More generally, the invention may be embodied as, or as part of, any electrical generator system.

In preferred embodiments where the turbine generator 10 is a hydroelectric turbine generator and is, in use, installed underwater, it is preferable to avoid the use of components that are susceptible to failure or wear. Therefore it is preferred that the turbine 16 has fixed pitch blades. It is also preferred that the generator 18 is a relatively low-speed generator coupled directly to the turbine 16 as opposed to a relatively high-speed generator coupled through gears. It is further preferred that the generator 18 is a permanent magnet generator, i.e. having permanent-magnet excitation, rather than arrangements that require brushes and slip rings or commutators. In preferred embodiments, the turbine 16 comprises a tidal-current turbine, for example an open centre turbine. The preferred generator 18 is a directly coupled permanent magnet generator.

In use the generator 18 converts mechanical energy generated by the turbine 16 to electrical energy. Typically the generator 18 is configured to produce a three-phase AC electrical power output. The generator output has a voltage and frequency that is proportional to a rotational speed of the turbine 16. It will be understood that arrangements with any suitable numbers of phases may be employed. In some designs of generators, it is possible to separate coils of the windings into groups to provide two or more outputs that are electrically isolated.

When installed, the turbine 16 and the generator 18 are part of an off shore underwater installation. The grid is located near to or on shore. Therefore one or more power transmission cables are provided to transmit generated electrical power from the underwater installation to the grid or other on shore / near shore delivery point. The generator 18 is provided in a water tight housing (not shown). The turbine 16, which may be provided externally of the generator housing, is coupled to the generator by a drive shaft 17, or a rim generator operating in water may be used. Other components of the electrical generation system, such as the power converter system 12 and/or the transformer 14, may be provided conveniently in a water tight underwater housing. For example, the power converter system 12 and the transformer 14 may be provided in the generator housing. However, in preferred embodiments, only part of the power converter system 12 is provided as part of the underwater installation, the remainder of the power converter system 12 and the transformer 14 being located at an on shore or near shore receiving station, conveniently at a grid connection point. This reduces the cost and size of the underwater installation, which is desirable.

In order for a significant amount of power to be transmitted from the turbine generator 10 to a grid connection point on shore, which may be typically several kilometres from the turbine, the power transmission cable(s) preferably operates at a high voltage. However, electrical elements within the turbine generator 10, such as generator windings, are normally designed to operate at much lower voltages for reliability and economy. One way to address this issue is to provide the power converter system 12 and transformer 14 at the underwater installation and to configure them such that high voltage AC power is produced for transmission to shore. For example the transformer 14 may be configured to transform the output of the converter system 12, which may be typically 400V or 690V, to an output voltage of 22kV for transmission to shore. However, this arrangement is incompatible with the desire to reduce the cost and size of the underwater installation, especially the generator housing.

If necessary, a further transformer (not shown) may be provided on shore for transforming the transmitted power to a voltage level suitable for the grid or alternatively, to a voltage suitable for connection to a subsequent stage of power conversion that may be needed prior to grid connection

Typically, a plurality of turbine generators 10 are interconnected electrically such that their generated electrical power is combined for delivery to the grid. This is illustrated in Figure 2 which shows a plurality of turbine generator units 20 having their respective output electrically connected together (in parallel), usually by relatively short power cables 22, and feeding at least one main power transmission cable 24 which carries the combined electrical power to a receiving station 26 that is connected to the grid. When installed the turbine generator units 20 are located under water off shore while the receiving station 26 is located on or near shore. The various components of the units 20 may be provided in one or more water tight housings, as is convenient.

The power converter system 12 is an AC to AC converter that converts the AC output power from the generator 18 into AC power with a different frequency and/or voltage. The power converter system 12 may be referred to as a frequency converter. The power converter system 12 comprises a first stage converter 28 and a second stage converter 30. The first stage converter 28 is a rectifier arranged to convert input AC power received from the generator 18, and having a frequency corresponding to a rotational speed of the generator 10, to DC power. The second stage converter 30 is an inverter arranged to convert the DC power provided by the first stage converter 28 to AC power, having a voltage and frequency that is compatible with the subsequent part of the generator system. The first stage converter 28 and second stage converter 30 may be connected by a DC link 32.

The first stage converter 28 may take any suitable form and may for example be a three-phase, phase-controlled rectifier, such as a thyristor bridge. Alternatively, the first stage converter 28 may be a thyristor AC controller, followed by a diode bridge. In preferred embodiments, the first stage converter 28 is a voltage-source inverter (VSI) converter, or voltage source converter. The VSI converter may comprise a transistor and diode bridge rectifier, usually a three-phase transistor and diode bridge rectifier, with at least one shunt capacitor at its DC output (DC link). For example, the first stage converter 28 may be a voltage-source inverter type converter operated as an active front end and arranged to operate with a fixed-voltage DC link / DC output. The first stage converter 28 may alternatively be a current-source inverter (CSI) type converter.

The second stage converter 30 may take any suitable form and may for example be a thyristor bridge operating as a phase-controlled, current-source, line-commutated inverter. Alternatively, the second state converter 30 may be of a CSI type.

In preferred embodiments, the power converter system 12 is arranged to control the operation of the turbine 16, and in particular, the rotational speed of the turbine, to ensure optimal power is generated at times when the water flow speed is less than a rated value, and limit the power generated at times when the water flow speed is greater than a rated value. To this end operation of the power converter system 12 may be controlled by a control unit (not shown) that is configured to determine an indication of the water flow speed through the turbine and to control the power converter 12 accordingly.

In preferred embodiments and as illustrated in Figure 2, the first stage converter 28 is provided as part of the underwater installation, more particularly as part of the respective turbine generator unit 20. Conveniently, the first stage converter 28 is provided in a water tight housing. However, the second stage converter 30 is preferably provided at the receiving station 26. Accordingly, each turbine generator unit 20 produces a DC electrical power output. Similarly the combined output from an array of electrically interconnected turbine generator units 20 is a DC electrical power output. Such an array of turbine generator units 20 may be referred to as a DC array.

A typical first stage converter of the types mentioned above might for example produce a DC output in the region of 400V to 1200V, which is considered not to be compatible with transmitting the generated power efficiently to shore. In accordance with one aspect of the invention therefore, a plurality of first stage (AC to DC) converters are coupled to a single generator, the respective DC outputs of the converters being electrically connected in series to produce a combined DC output.

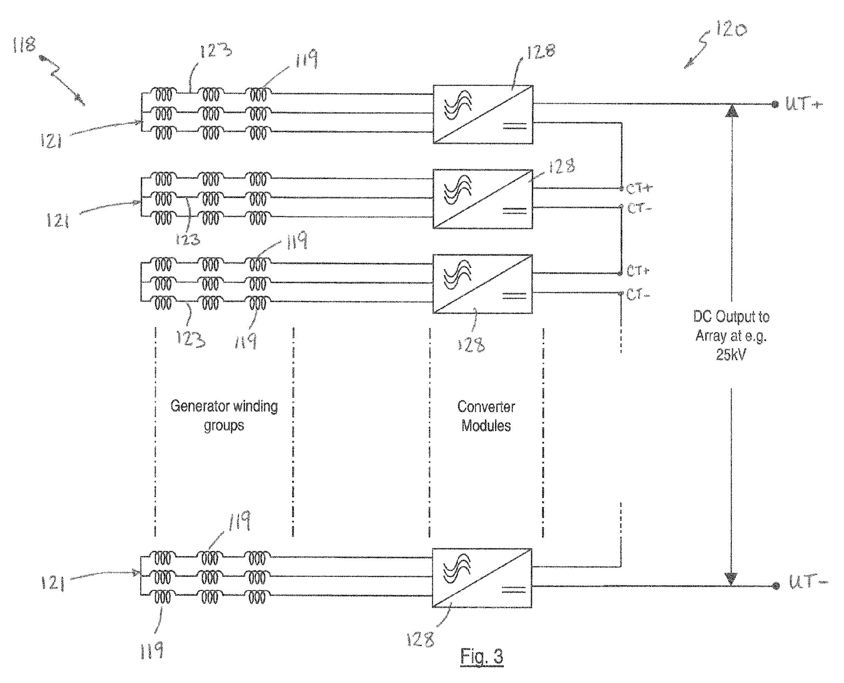

This is illustrated in Figure 3 which shows an electrical generator unit 120 suitable for use as the turbine generator unit 20. Electrical generator unit 120 comprises an electrical generator 118 of which only the generator windings 119 are shown. In this example, the generator 118 has multiple groups 121 of generator windings, each group 121 comprising one or more windings 119 for each phase of the AC output produced during use (usually an equal number of winding 119 for each phase). Typically, in each winding group, a respective winding circuit branch 123 is provided for each phase, each branch 123 having at least one winding 119, or coil. The branches 123 may be connected together, e.g. in a star or delta configuration. In the illustrated embodiments there are three windings per branch 123 by way of example only.

The generator 118 is assumed to produce a three phase AC output and so each winding group 121 has respective windings for each of the three phases. A respective AC to DC converter 128 is provided for each winding group 121. The converters 128 are multi-phase, in this case three phase, converters and have a corresponding multi phase input connected to the multi phase output of the respective winding group. Each converter 128 provides a DC output from DC terminals CT+, CT-. The respective DC terminals of the converters 128 are connected in series to provide a combined DC output at DC terminals UT+, UT- of the generator unit 120. It will be seen that a modular converter concept is employed whereby a plurality of relatively low-voltage AC to DC converter modules, preferably VSI converter modules, are connected in series at their DC terminals to create a relatively high-voltage DC output in order to transmit power efficiently to the receiving station. If the high voltage DC output of the generator unit is at the correct level for the grid, a transformer is not required at the receiving station 26.

A problem with the embodiment of Figure 3 is that the winding groups 121 connected to a respective converter that is at or close to the positive output terminal UT+ of the unit 120 are at a relatively high electrical potential with respect to electrical ground, and this can cause unacceptable electrical stress on the winding insulation.

In preferred embodiments, therefore, one or more transformers are provided between the first stage converters and the generator. The transformer(s) electrically couple the converters to the generator (in particular to the generator windings) but also electrically isolate (advantageously providing galvanic isolation) the generator windings from the converters.

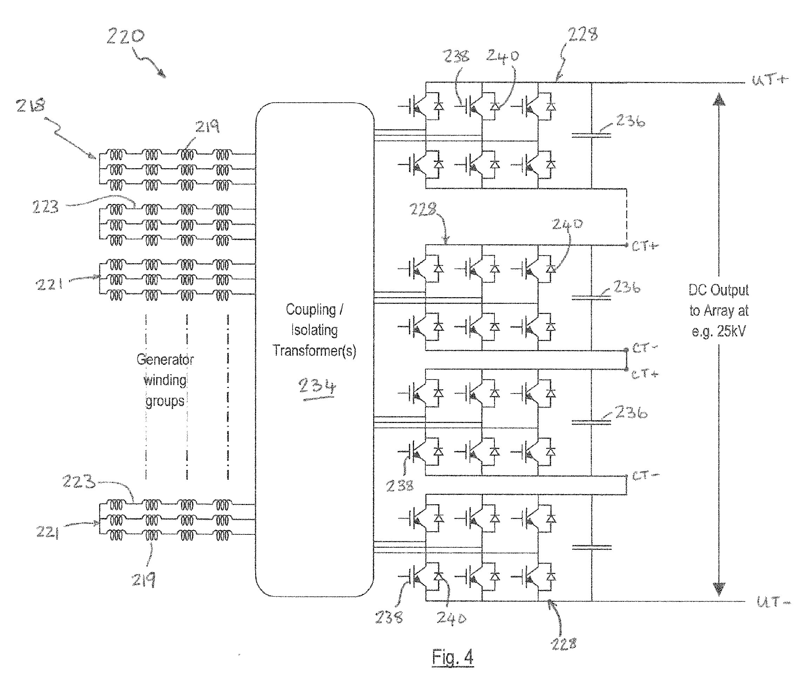

This is illustrated in Figure 4 which shows an electrical generator unit 220 suitable for use as the turbine generator unit 20 and which is similar to the unit 120 of Figure 3 and the same or similar description applies unless otherwise indicated. One or more transformers 234 are provided between the first stage converters 228 and the generator 218, which is represented in Figure 4 by groups 221 of windings 219.

Figure 4 also shows the preferred type of first stage converter (which may be used in any of the embodiments described herein), namely a VSI converter. The VSI converter module 228 provides a DC output from DC terminals CT+, CT-, which terminals may provide a DC link and the DC output between terminals CT+, CT- may be referred to as the DC link voltage. At least one shunt capacitor 236 is provided between the terminals CT+, CT-. The DC link of each VSI converter module 228 is connected in series to provide the combined DC output at terminals UT+, UT-. In the illustrated embodiment, each VSI converter 228 is a multi-phase, in particular three-phase, converter and has a corresponding multi-phase input. The VSI converter 228 comprises a multi-phase, in this case three-phase, bridge, each branch of the bridge comprising a semiconductor switch 238 and free-wheel diode 240. By way of example the switches 238 may be Insulated-Gate Bipolar Transistor, (IGBT) switching devices, or other types of switching such as Integrated Gate Commutated Thyristors (IGCT) or Gate Turn Off (GTO) thyristors. Advantageously, the DC link capacitor 236 maintains a substantially constant DC link voltage over a period of a switching cycle of the switching devices 238.

It is noted that in alternative embodiments, other types of first stage converter modules may alternatively be used, as discussed above.

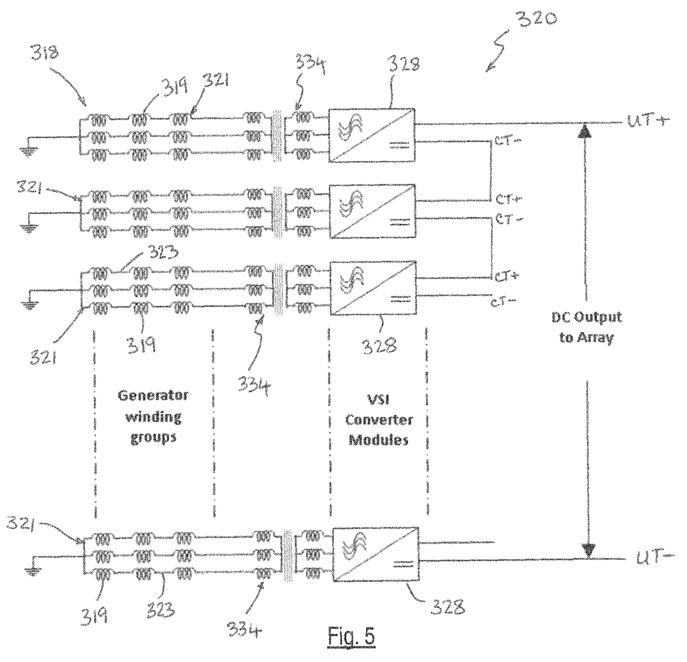

Figure 5 shows an electrical generator unit 320 suitable for use as the turbine generator unit 20 and which is similar to the unit 220 of Figure 4 and the same or similar description applies unless otherwise indicated. In this embodiment, a respective transformer 334 is provided between each first stage converter 328 (which is preferably but not necessarily a VSI converter) and a respective winding group 321 of the generator 318.

A plurality of generator units 20, 120, 220, 320 embodying the invention may be electrically connected in parallel to provide a DC array as described with reference to Figure 2. For example the respective outputs UT+, UT- may be connected in parallel by the array power cables 22 so that the aggregate DC power from all of the units in the array can be transmitted to the receiving station 26 via transmission cable(s) 24. The receiving station 26 could be similarly configured or it may use a smaller number of high-power medium-voltage converters.

By way of example, if each generator unit 20, 120, 220, 320 delivers up to 2.5MW of DC power, then for the case illustrated where the DC output voltage is 25kV, each first stage converter 28, 128, 228, 328 should have a DC current rating of 100A. IGBTs of this current rating are available as ready-assembled three-phase bridges, conveniently within a single module with matching gate drives and snubbers to fit directly above to minimize wiring and EMC problems. Bridge based devices rated up to 1200V are widely available and a few are available rated at 1700V. Each bridge using 1700V devices typically has a DC link voltage of up to approximately 1100V. Therefore, about 24 first stage converter modules comprising such bridges could be used in series to give the 25kV DC transmission voltage. A higher (or lower) DC transmission voltage could be arranged by using more (or fewer) converter modules in series.

If, for example, the illustrated generator 18, 118, 218, 318 has three windings (coils) 19 in series in each branch 123, and has 24 parallel winding groups 121, 221, 321, one option is to use a separate converter module 128, 228, 328 for each winding group 121, 221, 321, and connect their DC links in series as shown in Figures 3 and 5.

The transformer(s) 234, 334 may have a turns ratio of 1:1, i.e. such that there is no voltage step up or step down from the generator output to the converter input. Optionally, the or each transformer 234, 334 may have a turns ratio other than 1:1, i.e. such that there is a voltage step up or step down from the generator output to the converter input. Using transformers with a turns ratio other than 1:1 offers the possibility of designing the generator windings to operate at a voltage unconstrained by the converter voltage rating.

For example, with respect to the illustrated example, transformer(s) with a 2:1 turns ratio would allow the generator winding to have six series coils 19 instead of three and to use 12 parallel groups instead of 24, which would halve the amount of winding cable required. Alternatively, each winding coil 19 may be designed with a larger number of turns of thinner conductor; these would be simpler to build and could be connected using thinner cable.

As illustrated by way of example in Figure 5, generator units embodying the invention may have equal numbers of winding coil groups 121, 221, 321 and converter modules 128, 228, 328, i.e. a respective converter for each winding group. Optionally, a respective transformer 234, 334 is provided between each winding group and coupled converter. However, having multiple transformers increases the size and complexity of the generator unit. Advantageously, this constraint can be avoided by coupling at least two, and preferably all, of the converters 218, 318 to a common transformer, i.e. the same transformer. This may be achieved by combining multiple transformers into a single transformer unit with multiple windings. Such a transformer would be more compact and more efficient than an equivalent set of individual separate transformers.

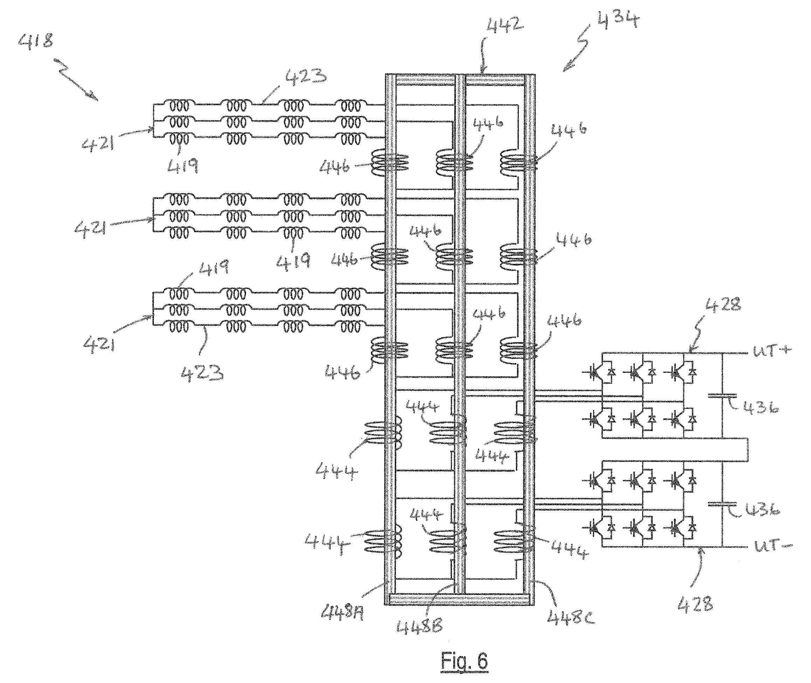

This is illustrated by way of example in Figure 6, which shows a generator 418, represented by its winding groups 421, coupled to a plurality of AC to DC converters 428 by a common transformer 434. The generator 418 is a three phase generator with three winding groups 421, each winding group having a circuit branch 423 for each phase, each circuit branch having four winding coils 419. It will be understood that in alternative embodiments there may be more or fewer phases, winding groups, circuit branches and/or windings per branch. Figure 6 shows two converter modules 428 although in alternative embodiments there may be more or fewer.

The transformer 434 has a transformer core 442 and a plurality of converter side transformer windings 444 and at least one but typically a plurality of generator side transformer windings 446 around the core 442. The core 442 typically has a respective core element 448 for each phase produced by the generator. For the exemplary three phase generator, there are three core elements 448A, 448B, 448C. Each core element 448 has at least one converter side winding and at least one generator side winding, the at least one converter side winding being electromagnetically coupled to the at least one generator side winding. As indicated previously, the turns ratio between respective generator side windings and converter side windings with which they are coupled may be 1:1 or other than 1:1, as desired (although typically the selected turns ratio is the same throughout the transformer, i.e. for each coupled winding group - converter pair). On each core element 448, there may be an equal or different number of generator side windings and converter side windings, i.e. there may be more generator side windings than converter side windings, or vice versa, or an equal number of each. This corresponds to whether there is an equal number or different number of winding groups 421 and converters 428 coupled together by the transformer 434. On the generator side of the transformer 434, each winding group 421 is connected to a respective generator side winding 446 for each phase (i.e. a three phase transformer winding or other multi-phase transformer winding). More particularly, each winding branch 423 of each winding group 421 is connected to a respective generator side winding 446. Typically, the respective generator side windings 446 are connected in series with the windings of the respective branch 423. In Figure 6, the respective generator side windings 446 have one end connected to the respective branch and the other end connected to a common point with the other generator side windings of the respective winding group. On the converter side of the transformer 434, each converter 428 is connected to a respective converter side winding 444 for each phase (i.e. a three phase transformer winding or other multi-phase transformer winding). More particularly, the respective converter input for each phase is connected to a respective converter side winding 444. Typically, the respective converter side windings 444 are connected in series with the respective converter input. In Figure 6, the respective converter side windings 444 have one end connected to the respective input and the other end connected to a common point with the other converter side windings of the converter.

The provision of the common transformer 434 as illustrated in Figure 6 allows there to be a different number of converters 428 compared to winding groups 423, although the common transformer may also be implemented with equal numbers of converters 428 and winding groups 423. This and the ability to select the turns ratio between respective generator side windings and converter side windings provides two degrees of design freedom, whereby on the generator side there is less restriction on output voltage produced by the generator, on the converter side there more freedom to create a desired combined DC output level, especially with available converter modules.

By way of example, the generator unit 420 may comprise 12 three-phase windings 446 for the generator side and 24 three-phase windings 444 for the converter side. Each of the 24 converters 428 may have an 1100V DC link so that the combined output voltage could be up to 26.4kV, a practical voltage for transmission to shore of up to about 30 to 40MW.

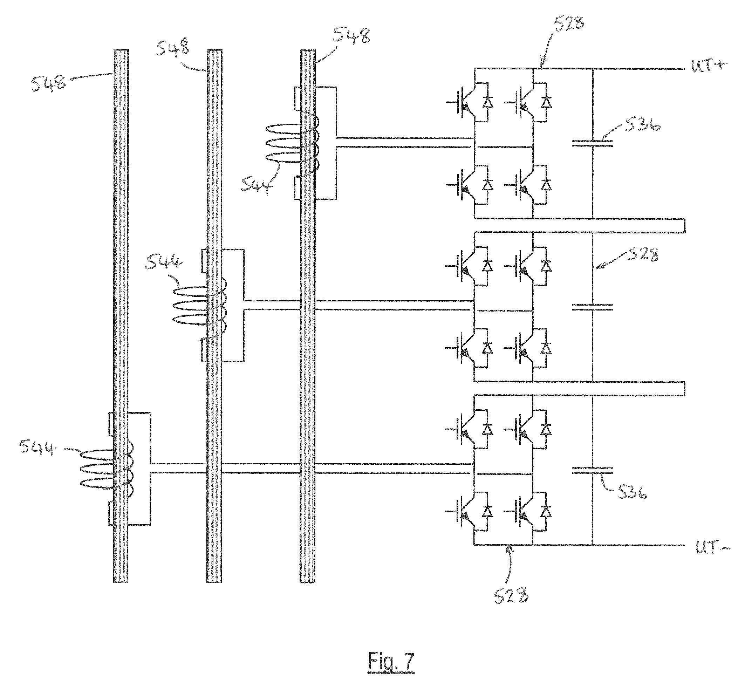

A relatively large number of transformer windings can be difficult to accommodate in a transformer of standard construction. The total number of converter-side windings could be reduced by two-thirds by using single-phase converters 528 as illustrated in Figure 7 instead of the multi-phase converters of the other embodiments described herein. Unfortunately, a single-phase converter bridge receives power varying from zero to twice the mean power. Therefore a relatively large DC capacitor 536 is needed to stabilise its DC link voltage. It is desirable to have a relatively low or minimum capacitance connected to the DC output of the converters and of the generator units to avoid high discharge currents from an array of generator units in the event of a cable fault. Therefore the three-phase converter is preferred and so a non-standard transformer construction is advantageous.

The usual form of transformer winding comprises concentric cylinders for the primary and secondary; it is very difficult to provide connections to the inner winding except at the ends of the cylinder and so it is not practical to divide the winding into isolated sections. An alternative arrangement used mostly for high-voltage transformers is to use a set of disc-shaped coils. Multiple connections are then straightforward.

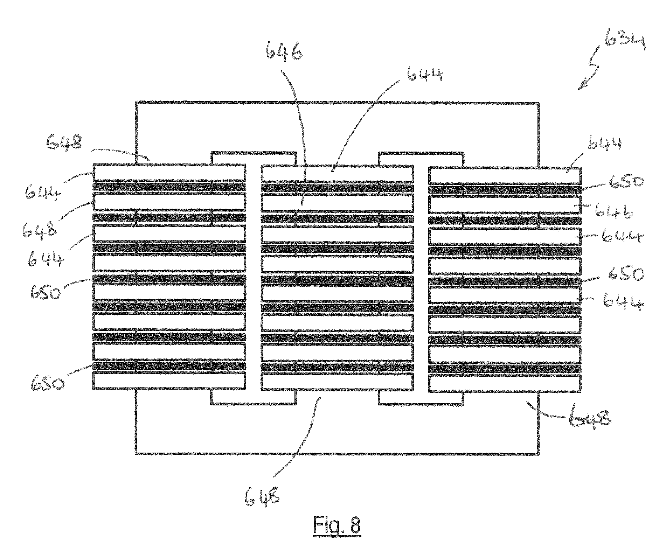

Figure 8 illustrates a preferred transformer construction that uses layered disc like transformer windings, and may be referred to as a pancake-coil construction. Each transformer winding comprises a disc-shaped coil provided around one or other of the transformer core elements 648. Each winding is separated from the or each adjacent winding by an electrically insulating layer 650 (any conventional transformer insulation material may be used). The insulation 650 separates the windings, which are held at different electrical potential. Preferably, the generator side windings 646 are interspersed with the converter side windings 644. In the example of Figure 8, the generator side windings 646 are alternated with the converter side windings 646. With interspersed windings, the transformer 634 has extremely low leakage reactance. In many transformer applications it is desirable to have low leakage reactance, however, in the present case a higher reactance is useful. Firstly, the reactance acts as a filter attenuating the switching-frequency voltages that the generator is subjected to; secondly, the additional inductance in the generator circuit extends the field-weakening capability so that the machine can better cope with transient peaks in the turbulent tidal flow.

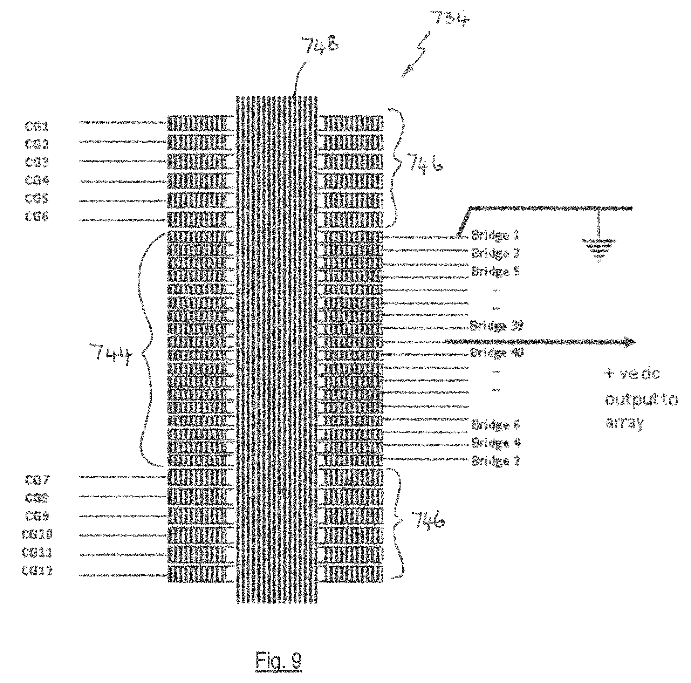

Figure 9 shows (only one phase of) an alternative transformer 734 in which the windings are rearranged such that the converter side windings 744 are grouped together and located between two sub-sets of the generator side windings 746. The arrangement shown in Figure 9 would provide higher leakage reactance and allow the windings 744 of the converter to be arranged so that the electrical potential difference between adjacent coils is no more than twice the converter bridge DC link voltage, or about 2200V. Care should be taken in the transformer design to limit the leakage flux density otherwise large eddy current losses may be caused in the windings. An intermediate degree of interspersal between that of Figure 8 and that of Figure 9 may be appropriate.

Concentric cylindrical windings naturally provide vertical channels for coolant; usually oil. Transformers with pancake coils are better suited to alternative cooling arrangements. One approach is to use thermal shunts. This involves providing heat conducting plates between coils to transmit heat to the outer surface where it can be removed by an air or liquid cooling system. Another approach is to employ direct water cooling. This involves forming the transformer windings from extruded copper conductors with internal water passages.

As noted above, a relatively low, or minimum, capacitance is desired at the DC link / DC output of the converters 28,128, 228, 328, 428 because, in the event of a cable fault, the stored energy is discharged into the fault. The capacitor 236, 436, 536 is needed to carry the ripple current produced by the high frequency switching of its associated AC to DC converter bridge. The amplitude of the ripple current is related to the AC current and so a smaller capacitor can be used if a high switching frequency is used. The relatively small switching devices used for the converter bridges are capable of very high frequency operation such as 10-20 kHz. The high frequency of the ripple current makes it advisable to use a capacitor with low effective series inductance and resistance such as a polypropylene film type. Furthermore, these have longer life than the electrolytic capacitors often used.

In typical embodiments where there is a relatively large number of AC to DC converter bridges in series it is desirable for the total voltage to be accurately shared amongst the converter bridges, otherwise excessive voltage might be applied to one bridge causing damage. However, during normal operation on preferred embodiments, each converter module 28, 128, 22, 328, 428 receives substantially the same input voltage because the transformer converter-side coils 444, 544, 644 all produce the same emf and, by causing every AC to DC converter bridge to be switched by the same signal the DC voltage produced will be the same.

In preferred embodiments, protection measures are adopted to ensure that the generator unit array continues to operate and deliver power to the grid following any of a range of potential electrical faults.

Faults within individual generator winding coils caused by shorting between turns would cause large induced currents to flow in the shorted turns causing high temperatures, swelling of the winding enclosure and extensive damage if this leads to contact with the rotor. Monitoring winding temperature and balance between phase currents and between winding groups can detect these faults. However, such faults are exceedingly rare in electrical machinery, even where simple random enameled-wire windings are used and operating up to 180°C. In preferred embodiments, both the generator coils and the proposed transformer coils comprise layered windings of strip conductor with half-lapped tape insulation, and the preferred water cooling ensures that temperatures remain very low by electrical insulation standards.

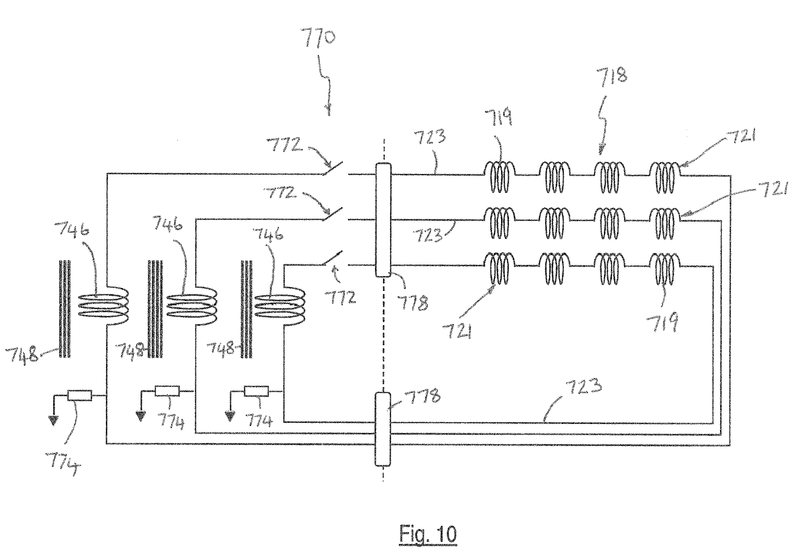

Insulation failures elsewhere in the generator winding system, such as a line-line short at a cable splice, may be isolated to prevent further damage by electromechanical or solid-state contactors on each winding group. Figure 10 shows a preferred fault protection apparatus 770 for a generator 718. The fault protection apparatus 770 is suitable for use with the generators 18, 218, 318, 418, 518 and embodies another aspect of the invention. The generator 718 is represented in Figure 10 by its windings 719. In Figure 10 only one generator winding group 721 is shown although in practice the generator 718 will have multiple winding groups. Preferably, a respective fault protection apparatus 770 is provided for each winding group 721. Each winding group 721 has a respective set of one or more windings 719, or winding coils 719, for each phase (usually an equal number for each phase). In the illustrated embodiment there are four winding coils 719 per phase, although there may be more or fewer in alternative embodiments. In typical embodiments, there are three phases (as illustrated) although in alternative embodiments there may be more or fewer phases. The respective windings 719 for each phase are provided in series in a respective winding circuit 723. Each winding circuit 723 additionally includes a respective transformer winding 746 in series with the winding coils 719. Each winding circuit 723 also includes a respective normally closed switching device 772, typically an AC circuit breaker, operable to break the respective circuit 723 in the event of a fault. The switch 772 is preferably located in series between the transformer winding 746 and the generator windings 719. The switch 772 may be operated by any convenient fault detection device (not shown) typically comprising a current sensor arranged to monitor the current in the respective circuit 723 and, in response to detecting a fault current, to cause the respective switch 772 to open (e.g. using relays or other switch activation means), thereby protecting the windings. To facilitate this, the circuit 723 may include an earthing resistor 774 (i.e. a resistor connected between the circuit 723 and electrical earth) of relatively high resistance, e.g. approximately 1000 ohms, the current sensor being arranged to monitor the current flowing through the earthing resistor 774. During use, any shorting fault causes just a small current to flow through the relevant high resistance earthing resistors 774. Such currents allow the fault to be detected and the switch 772 opened. Upon detecting a fault in a winding group the switches 772 of all winding circuits 723 of the group are preferably opened because the three phases in a winding group usually share common cables and coil enclosures. More generally, it is preferred to isolate and de-activate all circuits that share common cables, and housings because a fault detected in any one phase may be a symptom of, for example, an overheated or damaged region in a cable that would quickly lead to problems in other circuits sharing the cable, connector housing or other component. The respective switching devices 772 may be implemented as individually operable switching devices, or may be implemented as respective contacts of a single switch device such that all of the contacts 772 are operated at the same time.

Unlike conventional winding groups, the winding circuits 723 for the phases are not electrically connected to each other, e.g. they are neither star nor delta connected as is conventional, but are kept separate electrically. Advantageously, this means that the windings 719, 746 can be protected (isolated) by using just one switch 772 in the circuit 723. This is in contrast to conventional configurations of winding groups, e.g. those connected in star or delta, where at least two switching devices are required to isolate the generator windings 719 in the event of a fault. Therefore, embodiments of this aspect of the invention can provide a significant saving in terms of size and cost.

In typical embodiments, the switching devices 772 and fault detection devices may be provided in a module that may be electrically and mechanically connected to the generator winding group 721 by bulkhead connectors 778. The module may include or otherwise be connected to the transformer windings 746.

It will be seen that the fault protection apparatus 770 is suitable for use with generators that are connected to one or more transformers. This includes not only the generators of the generator units 20, 220, 320, 420, 520 described herein but also with any generator and generator system where the generator windings are connected to one or more transformer winding.

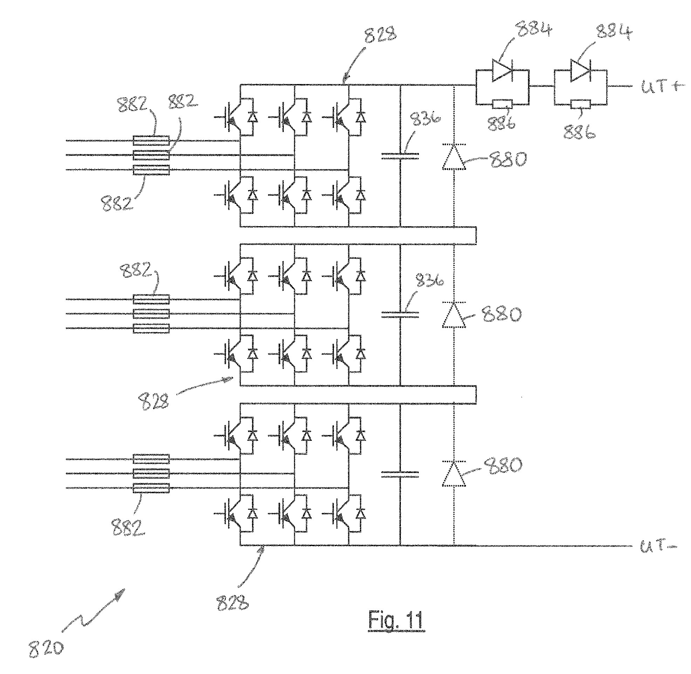

In preferred embodiments, a fault in one of the converter modules 28, 128, 328, 428, 528 is naturally bypassed through the freewheel diodes 240 in parallel with the IGBTS 238 that make up the rectifier bridge of the converter. With reference to Figure 11, an additional diode 880 may be connected in shunt across the DC output of the converter module 828, e.g. in parallel with the DC link capacitor as shown in Figure 11, if considered desirable for further assurance. In order for the respective generator (not shown in Figure 11) to continue operating, the faulted converter module should be disconnected from its transformer winding (not shown in Figure 11). This is most easily done by means of a respective fuse 882 in series between the respective converter module input and respective converter side transformer winding, as shown in Figure 11.

Figure 11 also shows diodes 884 provided in series with the DC output of the generator unit 820 that may be used to prevent a fault within one generator unit 820 affecting the operation of other generator units in the array. Typically, at least two diodes 884 in series are provided at the DC output (in this case connected to the positive DC terminal UT+). Multiple series diodes are usually required in order to withstand the array voltage and these should each preferably have a parallel voltage-balancing resistor 886, as shown in figure 11. The diodes 884 may be conveniently assembled from 1200V, 120A components having leakage current typically 0.1 mA. For example, they may operate at 1000V and use balancing resistors of about 1MΩ dissipating 1W when the diodes are reverse biased. Typically, the diodes 884 each dissipate about 100W when the generator is at full power and so they are preferably mounted on a set of heat sinks that are conveniently cooled by the same cooling system provided for cooling the converter modules (not illustrated).

Electric power grids can suffer voltage sags and low voltage faults, typically lasting for up to approximately 2 seconds. When such a fault occurs, a stipulation of the grid system may be that generator units must remain connected to the grid system and ready to generate as soon as the fault is cleared, otherwise the sudden loss of generation can destabilize the grid. During such a fault the turbine continues to produce power but the grid cannot accept it. The surplus energy causes the rotational speed and the capacitor voltage to increase. To avoid dangerous excursions, it is usual to fit a fast-acting electrical load to the generator unit that can absorb then dissipate the energy. Usually, in wind turbines with AC-DC-AC converters, this takes the form of a resistor connected to the DC link and controlled by a chopper.

In a DC tidal turbine array, which may for example comprise an array of generator units such as those described and illustrated herein, an option for preventing such excursions is to fit a common brake resistor and chopper (not shown) at the input to the DC-AC converter 30 at the onshore substation 26. In the event of a low voltage grid fault, the DC-AC converter 30 controller limits the current fed to the AC system and the power it absorbs from the DC array falls. As the DC voltage rises, the DC chopper controller senses the rise and is controlled to draw sufficient current to regulate the DC voltage to the nominal level. The turbines are, therefore, unaffected by the fault and continue to operate normally. When the fault clears, the chopper reduces the current fed to the braking resistor and normal generation into the grid resumes.

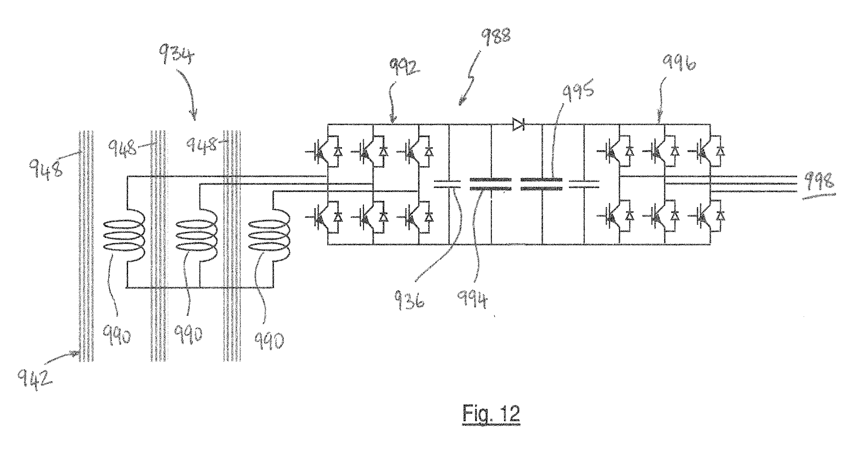

In DC arrays such as those described herein and illustrated in Figure 2, power cannot be drawn from the grid to provide auxiliary functions such kick starting the generator. Therefore, in preferred embodiments, the generator units 20, 220, 320, 420, 520, 820 include an energy storage system, an example of which is illustrated in Figure 12 as 988. In preferred embodiments, the generator unit is the same or similar to those described hereinbefore wherein the generator (not illustrated in Figure 12) is coupled to the main AC-DC converter(s) (not shown in figure 12) by a transformer 934. The transformer 934 is provided with an additional converter side winding 990 (i.e. in addition to the converter side windings described above for coupling the generator 18, 218, 318, 418, 518 to the AC-DC converters 28, 228, 328, 428, 528) around the transformer core 942. In the illustrated example, the additional winding 990 is three-phase winding provided around core elements 948. The additional transformer winding 990 is connected to the input of an auxiliary AC-DC converter 992 (i.e. a converter that is provided in addition to the main AC-DC converter(s) 28, 228, 328, 428, 528). The auxiliary converter 992 may be of the same configuration as any of the embodiments of the main AC-DC converters 28, 228, 328, 428, 528 described above). One or more energy storage device 994 is provided at the output of the auxiliary AC-DC converter 992. For example, the energy storage device 994 may comprise one or more capacitors (e.g. in shunt across the converter output terminals) or batteries. In the illustrated embodiment, a supercapacitor 994 is provided (in shunt) at the converter output for this purpose. The auxiliary converter 992 is operable (by any suitable controller (not shown) in a first mode in which AC power received from the generator via the transformer 934 is stored in the storage device 994, and in a second mode in which the stored DC energy is converted to AC power by the converter 992 and fed to the additional transformer winding 990. Since the transformer couples the additional winding 990 to the generator windings (not shown in Figure 12), in the second mode, the power provided by the auxiliary converter 992 can be used to kick start the generator (for example at the beginning of each new tide assuming that energy has been stored by operation of the auxiliary converter in the first mode during previous tide(s)). Optionally, an auxiliary DC-AC converter 996 may be connected to the output of the auxiliary AC-DC converter 992, and therefore to the energy storage device(s) 994, in order to provide an auxiliary AC power output 998 that may be used to provide auxiliary power to components of the generator unit when necessary.

Typically, the kick start function turns the generator as a motor at low speed, frequency and voltage usually for a just few seconds. The transformer winding 990 can therefore be designed to give the necessary current to the generator at low voltage using lower current at higher voltage from the auxiliary converter 992. By way of example, a small inverter using a bridge of 1200V devices would be sufficient for use as the auxiliary converter 992, and it could be similar or identical to the main bridge modules 28, 128, 228, 328, 428, 528. The supercapacitor bank can be recharged during subsequent normal operation of the generator by means of the kick start inverter operating in regenerative mode.

A respective supercapacitor 995 can also be used as the energy storage source for the DC input to the DC-AC converter 996, which may comprise a relatively small (e.g. about 1 kVA) inverter that may provide the 50 or 60Hz auxiliary electrical supply to the electrical system of the generator unit. The auxiliary inverter 992, 996 is typically small enough to be air-cooled by natural ventilation which means that during slack tides or other periods when the main converter modules are idle, the cooling system pumps or fans can be shut down to conserve energy.

The supercapacitors 994, 995 are typically not used as the main path for ripple currents produced by the kick start and auxiliary converters 992, 996; instead, a polypropylene film capacitor 936 of the type used in the main converter modules may be provided. The supercapacitor 995 used for essential auxiliary supplies should be separated from the AC-DC converter 992 and supercapacitor 994 of the kick start system so that it is not discharged below the threshold value for the auxiliary inverter to operate. A series diode 997 is provided between the auxiliary converters 992, 996 for this purpose. A possible specification for a suitable supercapacitor is given in the table below. Such a supercapacitor would support essential auxiliary loads such as control and monitoring circuits drawing, for example, 100W for a period of about 3 hours between tides.

| | | | |
|---|---|---|---|
| Cell capacitance | | *F* | 3000 |
| Voltage | | *V* | 2.7 |
| Charge | | *C* | 8100 |
| | | *A.h* | 2.25 |
| Number per module | | | 18 |
| Module voltage | | *V* | 48.6 |
| Modules | | | 15 |
| Totalvoltage | | *V* | 729 |
| Minimum voltage | | *V* | 560 |
| Energy | | *kJ* | 2952 |
| | | *kW.hr* | 0.82 |
| Usable energy | | *kW.hr* | 0.34 |

Following initial deployment of a turbine generator unit there is likely to be a long period before the unit becomes fully operational and the supercapacitors may not be available to provide energy as described. Energy sources that may be provided for charging the supercapacitors and so starting the system include:
A -- the generator array -- the supercapacitors can be charged by a current as little as a few 10s of mA. If a current of say 50mA is drawn from the power output of the array then it would charge a suitable supercapacitor in about 2 days.
B -- from the turbine -- The turbine 16 will start naturally in a moderate flow and so the supercapacitor may charge in the normal way if the generator windings are connected.

If an array fault occurs then the DC link capacitors 236, 336, 436, 536, 936 of all the generator units connected to form the array will discharge into the fault. Subsequently, the turbines 16 will continue to generate into the fault and the generator 18 will be effectively short circuited. Advantageously, however, the generator units 20, 120, 220, 320, 420, 520, 820 are configured to detect a reduction in the DC link voltage, and in response to such detection, to isolate or turn off the generator so that no current is fed into the fault. This may be achieved by opening the contactors of the generator winding groups, e.g. by opening switching devices 772 in embodiments that include the fault protection apparatus 770, or by opening one or more other contacts (not shown) that isolate the generator windings, or by operating the AC-DC converter to cause the DC link voltage to be zero. To minimize the damage caused by the initial fault current, the DC link capacitors of the AC converters 28, 128, 228, 328, 428, 528, 828 should preferably have the minimum possible DC link capacitance.

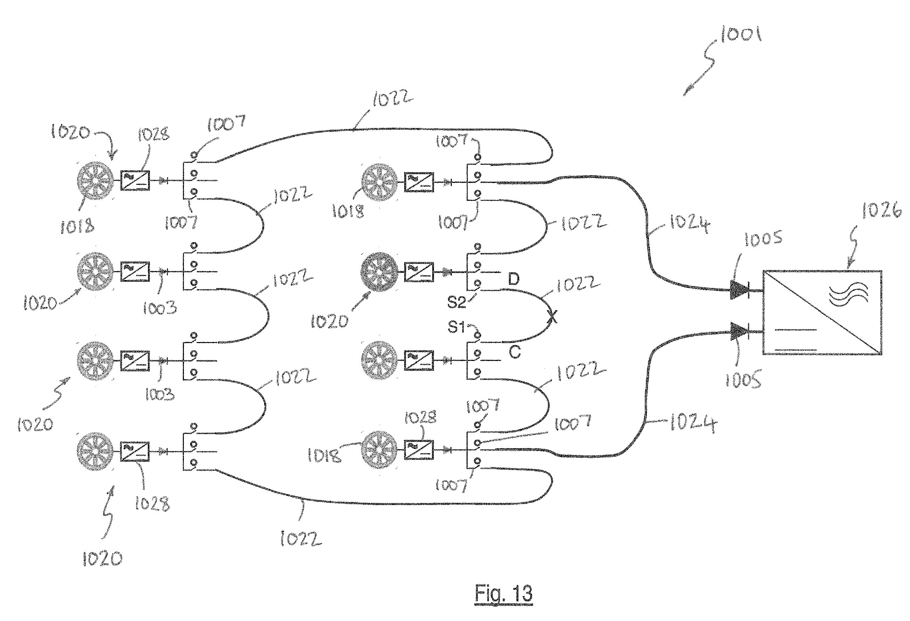

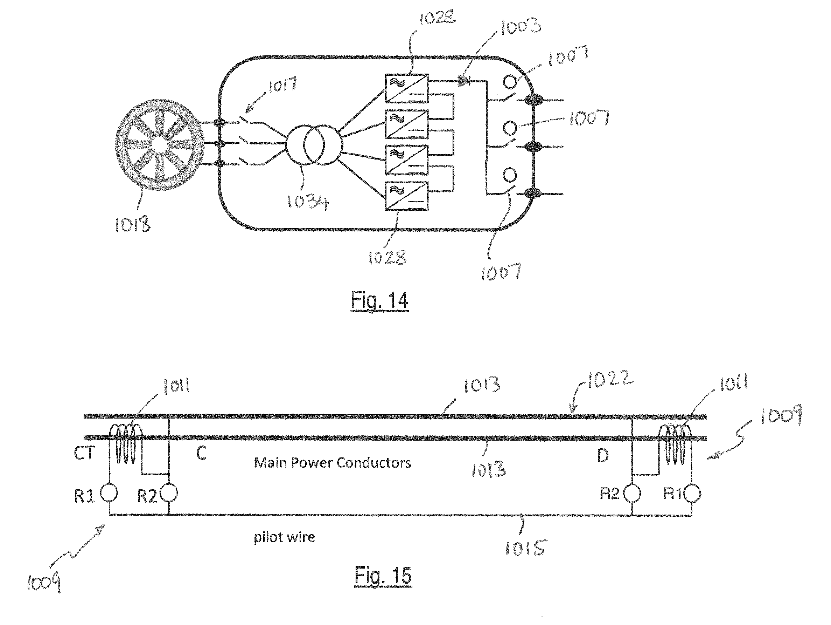

Typically, subsea cables that carry power to the receiving station 26 lie on exposed rocky seabed and so are vulnerable. In the likely event of a cable fault an alternative route for the current is desirable. It is preferred therefore that generator unit arrays have at least two power transmission cables (e.g. cables 24 in the example of Figure 2) to the receiving station 26. In this connection, Figure 13 illustrates a generator unit array 1001 embodying a further aspect of the invention. The array 1001 comprises a plurality of generator units 1020. Each generator unit 1020 includes a generator 1018 (which in typical embodiments is coupled to a turbine, in particular a tidal current turbine) and at least part of a power converter system (i.e. a respective AC-DC converter 1028 in preferred embodiments). In preferred embodiments, the generator units 1020 are of any one of the types described herein with reference to Figures 1 to 12. In particular, with reference to Figure 14, the generator units 1020 are preferably of a type that product a DC output, and so typically comprise the generator 1018 and at least one AC-DC converter 1028. The unit 1020 is preferably but not necessarily of the type described above that has multiple AC-DC converters 1028 with their outputs connected in series. Optionally a diode 1003 is provided at the converter output to prevent current flowing into the converter output. Optionally, the unit 1020 is of the type that includes one or more transformers 1034 coupling the generator 1018 to the AC-DC converter(s) 1028.

As described above the DC outputs of each generator unit 1020 in the array are connected together in parallel to produce a combined DC output from the array 1001. As such the preferred array 1001 may be described as a DC array. Typically, one or more switching devices or other output control means are provided for selectably reducing the DC output voltage from the generator unit 1020 to zero. The switching device(s) (which are represented in Figure 14 as 1017) may for example comprise switching devices 772 in embodiments that include the fault protection apparatus 770, or one or more other switches that may be solid state or have mechanical contacts and be operable to isolate the generator windings, or to operate the AC-DC converter to cause the DC link voltage to be zero, or otherwise turning off the DC output from the generator unit (e.g. the AC-DC converter itself may be used as the switching device).

The generator array 1001 is connected to the receiving station 1026 (which may be the same or similar to the receiving station 26) by at least two power transmission cables 1024, DC power transmission cables in preferred embodiments. Preferably, a respective diode 1005 is connected to each power transmission cable 1024 to prevent power from being transmitted from the receiving station to the array 1001. Each transmission cable 1024 is connected to a respective one of the generator units 1020, which may be designated as array output units, so that the combined DC output of the array may be transmitted to the receiving station by any one or each of the array output units 1020. Each array output unit 1020 is also connected to at least one other of the generator units 1020 in order to receive the DC output from the respective connected generator unit 1020. Each generator unit 1020 that is not an array output unit is connected to one or more array output unit 1020 and/or to one or more other non-array output generator unit 1020 so that its DC output can be transmitted to any one or each of the units 1020 to which it is connected. The connections between the units 1020 are made by respective lengths of power transmission cable 1022, DC power transmission cable in preferred embodiments.

In preferred embodiments, at least those generator units 1020 that are not array output units are connected to at least two other generator units 1020 (which may or may not be array output units). In particularly preferred embodiments, all of the generator units 1020 in the array are connected to at least two other generator units 1020 (which may or may not be array output units). The preferred arrangement is such that the DC output from any of the generator units 1020 can be provided to any one or each of the power transmission cables 1024 either directly (in the case where the unit 1020 is an array output unit), or by a direct connection with an array output unit, or as an end unit of a string of two or more interconnected non array output units the other end unit of which is connected to an array output unit.

In the illustrated embodiment, the generator units 1020 of the array 1001 are inter-connected to form a ring, as is illustrated in Figure 13 by way of example. They may alternatively be interconnected as a string in which a respective array output unit provides each free end of the string. Alternatively still, the generator units 1020 may be arranged to form multiple strings of generator units, each string having first and second generator units by which they are connected to one or more other strings at the respective first and second generator units. The first and second generator units may be located at either end of the respective string, and each string may have one or more additional generator units connected between its first and second units (i.e. the first and second units may be the end units of the respective string). Any one or more of the strings may include a respective one or more of the array output units, which may or may not be the same as the first and second unit of the string. For example, the array 1001 of Figure 13 may be said to comprise two such strings (one shown on the left and one shown in the right), each comprising four generator units 1020. One or more additional strings of generator units (not shown) may be connected to the array of Figure 13, each string being connected to one or more adjacent strings at the respective ends.

Each generator unit 1020 includes at least two switching devices 1007 that are operable to selectably connect the DC output of the generator unit 1020 to a respective transmission cable 1022, 1024, and so to connect or disconnect the generator unit 1020 to/from another generator unit in the array or to/from the receiving station 1026 as applicable. In preferred embodiments, each generator unit 1020 has at least two of the switching devices 1007, each being operable to connect or disconnect the generator unit 1020 to/from a respective other generator unit 1020 in the array 1001. Each generator unit 1020 that is an array output unit has an additional switch device 1007 for connecting and disconnecting it to/from the respective power transmission cable 1024 that carries DC power to the receiving station 1026. Each generator unit 1020 that is a first or second unit as described above for connecting strings of generator units has an additional switch device 1007 for connecting and disconnecting it to/from the respective power transmission cable 1022 that connects it to the respective first or second generator unit of the connected string.

In normal operating conditions (i.e. in the absence of a cable fault being detected), all of the switches 1007 are closed (i.e. so that the respective connection is made). In this state, the DC output from each non-array output generator unit 1020 will be transmitted to any one or each of the array output units 1020 by one or more circuit paths involving one or more other generator unit 1020 and/or one or more transmission cables 1022 as applicable, and subsequently be transmitted to the receiving station 1026 by the, or each, output generator unit 1020.

In the event that a cable fault is detected in a transmission cable 1022 inter-connecting two generator units 1020, the respective switch 1007 at each end of the faulty cable 1022 (i.e. a respective switch 1007 of each of the relevant generator units 1020) is opened to isolate the faulty cable. The switches 1007 are preferably opened after the DC current in the array, and therefore the fault current, has been reduced to zero. After the fault has been isolated, the generator units can be re-energised or otherwise re-activated. In response to this, any DC current that, prior to the fault, was being transmitted by the faulty cable is re-directed to reach one or more of the array output units 1020 by another route through the array. For example, with reference to Figure 13, if a cable fault X occurs in the cable 1022 between locations C and D in the array 1001, upon detection of the fault, switches S1 and S2 open to isolate the faulty cable. Subsequently, any DC power that was being transmitted between locations C and D is re-routed to any one or each of the array output units 1020 by an alternative route through the array.

If a fault is detected in any one of the main power transmission cables 1024 to the receiving station 1026, then the respective switch 1007 that connects the respective array output generator unit 1020 to the faulty cable is opened to isolate the array 1001 from the faulty cable. As indicated above, in preferred embodiments, the switch 1007 is opened only after the DC current in the array has been brought to zero by any convenient means, e.g. by opening the generator winding switches (of all generator units in the array). Once the faulty cable has been isolated, the generator units are re-activated and the DC power generated by the array 1001 is transmitted to the receiving station 1026 via the (or each) non-faulty cable 1024. Any DC power that was being transmitted via the faulty cable may be re-routed through one or more of the generator units 1020 as required to reach the array output unit connected to the non-faulty cable 1024. Detecting a fault in the cables 1024 may be achieved by any convenient means. For example, the array 1001 may have a fault detection system (not illustrated) configured to detect if the DC current at the array end of the respective transmission cable 1024 exceeds the DC current level received at the receiving station end of the cable 1024 and, if so, to determine that there is a fault in the cable 1024. To this end, any suitable fault detection device, e.g. comprising a current sensor, may be provided at each end of each transmission cable 1024. Any convenient communication and/or signaling channel may be provided between the receiving station and the array to allow this fault detection to be performed.

A fault in an array output cable 1024 may be detected by a current transformer at the array output generating unit 1020 by detecting the direction of the current pulse. If the fault is in the cable then there is a sudden rise in current at the generating unit 1020 whereas if the fault is elsewhere the current suddenly falls to zero. In either case the current transformer responds to the change and produces a pulse of secondary current whose direction indicates whether the fault is in the transmission cable or not.

In order to detect cable faults, the generator units 1020 may be provided with any conventional fault detection apparatus. Typically each generator unit 1020 is provided with a respective fault detection device for each transmission cable to which it is connected. The or each fault detection apparatus is preferably configured to detect not only the presence of fault current but also the direction of current flow, or more particularly to determine if current is flowing into a cable 1022 at one end and out of the cable 1022 at the other end (which is the case with no fault), or into the cable 1022 at both ends (which would be the case in the event of a fault).

As illustrated in Figure 15, the fault detection apparatus may comprise a respective fault detection device 1009 at each end of the cable 1022 (for example at locations C and D in Figure 13), the devices 1009 being coupled, or otherwise co-operable, to detect the direction of current flow at the respective ends of the cable. Each detection device 1009 may comprise a current transformer (CT) 1011, or other current sensor, coupled to a conductor 1013 of the cable 1022. The current transformers 1011 may be connected to each other by a pilot wire 1015. Each CT 1011 has a respective relay R1, R2 between each end and the pilot wire 1015. It is understood that a current transformer is essentially an ac device and so cannot detect the presence of the dc current under normal conditions, however when a fault occurs the discharge of the capacitors produces a sudden pulse of fault current which the current transformer will detect. In the event that a pulse of fault current flows into end C, then relay R1 at end C is activated and a signal is created to indicate that a fault has occurred and that the generator unit should be shut down. If the direction of the pulse is the same at each end of the cable 1022, then the pulses generated in the two windings of the CTs continue along the pilot wire 1015 and relay R2 is not activated. However, if the pulses are in opposite directions or if the pilot wire is broken then R2 is activated, which may for example cause the cable switch 1007 to be primed for opening once the DC current has been reduced to zero. In any event, a pulse of discharge current is sensed at each relevant switch 1007 (i.e. on either side of the fault) and a resultant signal is transmitted to the adjacent generator unit 1020 along the pilot wire 1015, e.g. a signal wire or optical fibre, which may be embedded in the main cable 1022. If the cable 1022 is healthy then the pulse is in the same direction as the pulse sensed at the other end of the cable and no action is needed. If the pulses differ in direction or the signal is lost then that cable is the location of the fault and the switches 1007 should be primed to open when the current has been reduced to zero. For example, in Figure 13, current flows into a fault at X from both C and D and so opening those switches isolates the fault. Alternatively a central fault monitoring system may be provided. It will be understood that the fault detection system of Figure 15 is exemplary only and that any suitable conventional fault detection system may be provided to indicate the presence of a fault, e.g. at location X, and after the generator units have been temporarily deenergised, to reduce the fault current to zero, the two relevant switches 1007 are opened so that the fault is isolated and then the generator units can be re-activated.

In preferred embodiments, each generator unit 1020 has two connections to the array 1001 and, in the case of the array output units, or units at the ends of strings of generator units, a third connection to a cable leading to the receiving station 1026. Any cable fault in this network can be isolated by opening two switches 1007 and allowing current to divert. A cable fault in a main transmission cable 1024 to the receiving station 1026 can be detected in any conventional manner and, in response to detection, the respective switch 1007 of the respective array output unit is opened to isolate the array 1001 from the faulty cable 1024.

It is not practicable to break direct current at high voltage and so the switches 1007 illustrated in Figure 13 are preferably simple make or break contact switches, e.g. motorized isolators, that are operated only when the DC current has been reduced to zero by other means. This can be achieved by, for example, opening the switches 1017 of the generator winding groups. It is also advisable to ensure that the DC-AC converter at the receiving station 1026 does not allow current to flow in reverse from the grid back to the array 1001, for example by means of the series diode 1005 at the dc input to the converter.

The array 1001 may include a communications system (not shown), for example comprising a communication/control unit in each generator unit 1020, and one or more communication links (e.g. a signal wire or fibre optic cable included with the cable 1022) between the units 1022 to enable each unit 1020 to be informed of a fault detected at another unit 1020, in response to which the non-faulty units 1020 isolate their generator or otherwise reduce their output current to zero to allow the switches 1007 to be opened. More conveniently, however, in preferred embodiments, each generator unit 1020 is configured to detect a fault (in its own cables or at another generator unit 1020) by monitoring the DC link voltage at its own output and, upon detecting a fall in DC link voltage to zero or to below a threshold, to determine that a cable fault is present somewhere in the array and to isolate its generator or otherwise reduce its output current to zero to allow the switches 1007 to be opened to isolate the fault.

In preferred embodiments, the generator units are turbine generator units as described above, especially hydroelectric turbine generator units, and more particularly tidal current turbine generator units. It will be understood however that aspects of the invention may be embodied in generator units generally, or in wind turbine generator units.

The invention is not limited to the embodiment(s) described herein but can be amended or modified without departing from the scope of the present invention.

## Claims

1. An electrical generator unit for providing a DC electrical output, the generator unit comprising:
an electrical generator configured to produce an AC electrical output;
a plurality of AC to DC converters, each converter being coupled to the generator to receive an AC electrical input from said AC electrical output, and being configured to produce a respective DC electrical output at a respective converter output,
wherein said respective converter outputs are connected together in series to provide the output of said generator unit.

2. The generator unit of claim 1, wherein each of said AC to DC converters comprises a voltage source converter, and wherein, typically, at least one respective shunt capacitor is provided across each converter output.

3. The generator unit of claim 1 or 2, wherein said generator comprises a plurality of generator winding groups, a respective AC to DC converter being coupled to a respective winding group to receive said respective AC electrical input from said respective winding group.

4. The generator unit of any preceding claim, wherein said AC to DC converters are coupled to said generator by at least one transformer, and wherein at least some and optionally all of said AC to DC converters may be coupled to said generator by a respective transformer, and wherein, optionally, at least some and optionally all of said AC to DC converters are coupled to a respective generator winding group by a respective transformer.

5. The generator unit of any preceding claim, wherein at least two of said AC to DC converters are coupled to said generator by a common transformer, optionally each of said AC to DC converters being coupled to said generator by a common transformer.

6. The generator unit of claim 5, wherein said common transformer comprises at least one generator side transformer winding and at least one converter side winding, and wherein said common transformer optionally comprises at least one respective converter side winding connected to a respective one of said at least two AC to DC converters, and wherein, typically, said generator comprises a plurality of generator winding groups, said common transformer comprising at least one respective generator side winding connected to a respective one of said generator winding groups.

7. The generator unit of claim 5 or 6, wherein said generator comprises at least one generator winding group by which it is coupled to said common transformer, and wherein the number of AC to DC converters coupled to said common transformer may be equal or not equal to the number of winding groups coupled to said common transformer.

8. The generator unit of any one of claims 5 to 7, wherein said generator includes at least one set of at least one generator winding, and typically at least one generator winding group comprising a respective plurality of said sets, each generator winding group usually comprising a respective set for each phase of the AC output of the generator, and wherein said common transformer has a respective generator side transformer winding connected to said at least one set of at least one generator winding, and wherein, preferably, said common transformer has a respective generator side transformer winding connected to each set of each winding group that is coupled to the transformer.

9. The generator unit of any one of claims 5 to 8, wherein said at least two AC to DC converters each has at least one respective input, typically a plurality of inputs, usually a respective input for each phase of the AC output of the generator, said common transformer having a respective converter side transformer winding connected to each input.

10. The generator unit of any one of claims 5 to 9, wherein said at least two AC to DC converters are multi-phase, typically three phase, converters, having a respective input for each phase, said common transformer having a respective converter side transformer winding connected to each input, and coupled in use to at least one generator side winding for the respective phase.

11. The generator unit of any one of claims 5 to 9, wherein said at least two AC to DC converters are single phase converters having a respective single phase input, said common transformer having a respective converter side transformer winding connected to each input, and coupled in use to at least one generator side winding for the respective phase.

12. The generator unit of any one of claims 5 to 11, wherein said transformer has at least one transformer core element, wherein at least one generator side winding and at least one converter side winding are located around a common core element, and wherein, optionally, the number of converter side windings and the number of generator side windings provided around a respective common core are unequal, and wherein, typically, the transformer has a plurality of core elements, a respective set of one or more generator side windings and converter side windings being located around each core element and wherein, typically, the transformer has a respective core element for each phase of the generator AC output, a respective set of one or more generator side windings and converter side windings for each phase being located around the respective core element for the respective phase.

13. The generator unit of any one of claims 5 to 12, wherein the generator comprises at least one generator winding group having a respective set of one or more generator windings for each phase of the AC output of the generator, each set being included in a respective electrically separate winding circuit, wherein each winding circuit includes a respective transformer side winding in series with the or each generator winding of the respective set, said respective winding circuit further including a respective normally closed switching device operable to break the respective winding circuit in the event of a fault, said generator unit further including fault detection means configured to detect a fault in any one of said winding circuits, and in response to detecting a fault to cause the respective switching device to break the respective winding circuit, and wherein, optionally, the respective switching device is located in series between the respective transformer winding and the respective set of one or more generator windings, and wherein, optionally, each winding circuit includes a respective resistor connected between the winding circuit and electrical earth, the fault detection means being arranged to monitor the current flowing through the resistor and to detect a fault if the current exceeds a threshold level, and wherein the generator unit preferably includes means for operating the respective switching device to break the respective winding circuit in response to detection of a fault at the output of the generator unit.

14. The generator unit of any preceding claim, wherein said generator is coupled to a turbine, preferably a tidal current turbine.

15. The generator unit of any one of claims 5 to 14, further comprising an energy storage system, the energy storage system comprising an auxiliary AC-DC converter coupled to said at least one transformer, and one or more energy storage device, for example one or more capacitors, provided at the output of the auxiliary AC-DC converter, and wherein, typically, the auxiliary converter is operable in a first mode in which AC power received from the generator via the transformer in use is stored in the or each energy storage device, and wherein, optionally, the auxiliary converter is operable in a second mode in which stored DC energy is converted to AC power by the converter and provided to the generator via said at least one transformer, and wherein, optionally, an auxiliary DC-AC converter is connected to the output of the auxiliary AC-DC converter and is operable to provide an auxiliary AC power output.
